# EUROPÄISCHE PATENTSCHRIFT

(11) **EP 1 738 622 B1**
(45) Veröffentlichungstag und Bekanntmachung des Hinweises auf die Patenterteilung: **07.05.2008**
(21) Anmeldenummer: 05716874.2
(22) Anmeldetag: 02.03.2005
(51) Int. Cl.: H05K 3/00, H05K 1/00, H01L 21/78

(54) **LEITERPLATTENNUTZEN MIT EINER VIELZAHL AN SCHALTUNGSTRÄGERN UND VERFAHREN ZUM VEREINZELN VON SCHALTUNGSTRÄGERN AUS EINEM LEITERPLATTENNUTZEN**
CIRCUIT BOARD PANEL WITH A PLURALITY OF CIRCUIT CARRIERS AND METHOD FOR INDIVIDUALLY SEPARATING CIRCUIT CARRIERS BELONGING TO A CIRCUIT BOARD PANEL
SURFACE UTILE DE PLAQUETTE DOTEE D'UNE PLURALITE DE PORTE-CIRCUITS ET PROCEDE POUR ISOLER DES PORTE-CIRCUITS D'UNE SURFACE UTILE DE PLAQUETTE

(30) Priorität: 24.03.2004 DE 102004014438
(43) Veröffentlichungstag der Anmeldung: 03.01.2007
(73) Patentinhaber: SIEMENS AKTIENGESELLSCHAFT, 80333 München (DE)
(72) Erfinder: MÜNCH, Thomas, 93164 Laaber (DE); RAPPL, Hans, 93152 Nittendorf (DE)
(86) Internationale Anmeldenummer: PCT/EP2005/050910
(87) Internationale Veröffentlichungsnummer: WO 2005/094146

(56) Entgegenhaltungen:
- EP-A- 0 396 524
- US-A- 5 047 279
- US-A- 5 773 764
- US-A1- 2004 018 373
- US-A1- 2004 043 537
- PATENT ABSTRACTS OF JAPAN Bd. 2000, Nr. 21, 3. August 2001 (2001-08-03) & JP 2001 102486 A (SEIKO EPSON CORP), 13. April 2001 (2001-04-13) & US 6 774 500 B1 (NAKAYAMA TOSHINORI) 10. August 2004 (2004-08-10)

## Beschreibung

Die Erfindung betrifft einen Leiterplattennutzen gemäß dem Oberbegriff des Anspruchs 1. Die Erfindung betrifft weiterhin ein Verfahren zum Vereinzeln von Schaltungsträgern aus einem Leiterplattennutzen.

Bei der Herstellung sind Schaltungsträger in der Regel in einem Leiterplattennutzen angeordnet, um eine kostengünstige und effiziente Herstellung zu ermöglichen. Das Trägermaterial des Leiterplattennutzens und damit der Schaltungsträger ist vielfach ein nichtorganisches Material, z.B. eine Keramik. Das Vereinzeln der im Nutzen vorliegenden Schaltungsträger kann entweder durch einen manuellen Brechvorgang oder ein vollständiges Durchtrennen jeweils längs der Trennlinien erfolgen. Für den Fall, dass das Vereinzeln durch Brechen erfolgt, sind die Trennlinien in Form von Ritzmustern auf der oder den Außenlagen des Trägermaterials ausgebildet. Für den Fall, dass die Schaltungsträger durch ein vollständiges Durchtrennen des Trägermaterials des Leiterplattennutzens vereinzelt werden, können die Trennlinien auch lediglich in Form von optisch aufgebrachten Markierungen vorgesehen sein. Herstellungstechnisch wird ein Vereinzeln mittels eines Brechvorganges gegenüber einem Säge- oder Schneideprozess bevorzugt, da letztere wesentlich aufwendiger durchzuführen sind.

Beim Vereinzeln der im Nutzen vorliegenden Schaltungsträger - insbesondere wenn es sich um ein nichtorganisches Material handelt, welches einem Sinterschritt unterzogen wurde - kann es durch das Trennen der auf das Format der Schaltungsträger vorgeritzten Nutzen zu unkontrollierten Rissbildungen, vor allem im Bereich der Kreuzungspunkte der Ritzungen, kommen. Rissbildungen sind vor allem dann besonders häufig zu beobachten, wenn zwei sich kreuzende Trennlinien nicht-orthogonal zueinander verlaufen.

Sofern die Schaltungsträger lediglich mit einer auf der Oberfläche aufgebrachten Metallisierungsschicht versehen sind, können während des Brechvorganges beschädigte Schaltungsträger aussortiert werden. Damit ist sichergestellt, dass lediglich einwandfreie Schaltungsträger für die weitere Verarbeitung herangezogen werden. Bei so genannten Mehrlagenprodukten, bei denen eine Mehrzahl an Metallisierungsschichten im Inneren des Trägermaterials ausgebildet sind, können Rissbildungen jedoch zu unerwünschten Problemen führen, da ein lateraler Rissverlauf in den Bereichen von metallisierten Innenlagen visuell nicht inspiziert werden kann, so dass eine optische Kontrolle in der Regel nicht mehr ausreichend ist.

Dies hat zur Folge, dass derzeit bei der Herstellung von Schaltungsträgern mit zumindest zwei nicht-orthogonal aneinander grenzenden Seitenrändern zur Ausbildung einer Ecke ein vollständiges Durchtrennen des Trägermaterials notwenig ist. Hierdurch erhöhen sich jedoch mit Nachteil die Fertigungskosten und die Fertigungsdauer.

Ein gattungsgemäßer Leiterplattennutzen ist aus der EP 0 396 524 A1 bekannt. Der dort beschriebene Leiterplattennutzen umfasst eine obere, leitende Schicht und eine untere, leitende Schicht, welche über eine isolierende Schicht miteinander verbunden sind. Die Trennlinien sind in der oberen und unteren leitenden Schicht ausgebildet. Diese sind in Form von Schlitzen gebildet, welche sich durch die obere bzw. untere Schicht erstrecken und weiterhin Abschnitte mit Material der oberen bzw. unteren Schicht aufweisen, so dass eine bestimmte geometrische Figur ausgebildet ist. Schlitze und Materialabschnitte in der unteren, leitenden Schicht liegen Materialabschnitten und Schlitzen der oberen, leitenden Schicht gegenüber. Die Vereinzelung von in dem Nutzen ausgebildeten Mikro-Schaltplatten erfolgt durch Stanzen oder Schneiden. Beim Vereinzeln der Leiterplatten aus dem Leiterplattennutzen wird dadurch ein Kurzschluss zwischen der oberen und der unteren leitenden Schicht vermieden, wenn sich eine der oberen oder unteren leitenden Schicht während des Stanzvorgangs definiert verformt.

Ein mehrlagiger Leiterplattennutzen ist aus der US 5,047,279 bekannt. Eine Vereinzelung des Leiterplattennutzens in einzelne Schaltungsträger erfolgt im Bereich V-förmiger Gräben im Bereich äußerer Schichten des Leiterplattennutzens.

Weitere Leiterplattennutzen sowie Verfahren zum Vereinzeln von Schaltungsträgern aus dem Leiterplattennutzen sind aus der US 2004/0018373 A1 sowie der US 5,773,764 bekannt.

Es ist daher Aufgabe der vorliegenden Erfindung, einen Weg zum Vereinzeln von Schaltungsträgern aus einem Leiterplattennutzen aufzuzeigen, der die im Stand der Technik vorhandenen Nachteile nicht mehr aufweist.

Diese Aufgabe wird mit einem Leiterplattennutzen mit den Merkmalen des Patentanspruches 1 sowie mit einem Verfahren zum Vereinzeln von Schaltungsträgern aus einem Leiterplattennutzen mit den Merkmalen des Anspruches 6 gelöst. Vorteilhafte Ausgestaltungen ergeben sich jeweils aus den abhängigen Ansprüchen.

Der Erfindung liegt die Erkenntnis zugrunde, dass ein mechanisch ausgelöster Bruch in seinem Rissverlauf mit einer Energiewelle inter- oder intrakristallin fortschreitet, wobei die Energiewelle jedoch nicht gezielt einen engen Kurvenradius bei einer Winkeländerung vollziehen kann. Die Erfindung sieht deshalb vor, in den Leiterplattennutzen - vor dem Vereinzeln in Schaltungsträger - an zumindest manchen Kreuzungspunkten der Trennlinien durch das Trägermaterial des Leiterplattennutzens hindurchreichende Durchgangsöffnungen vorzusehen. Vorzugsweise sind die Durchgangsöffnungen an solchen Kreuzungspunkten zweier Trennlinien vorgesehen, an denen sich zumindest zwei Trennlinien in einem nicht-orthogonalen Winkel kreuzen. Die Durchgangsöffnungen lassen die Energiewelle beim Vereinzeln durch ein Brechen längs der Trennlinie gezielt enden, so dass unerwünschte Rissverläufe in lateraler Richtung unterbunden werden können. Auf diese Weise ist vorteilhafterweise sichergestellt, dass das Vereinzeln der Schaltungsträger aus einem Leiterplattennutzen, unabhängig von der endgültigen Form (insbesondere der Größe und der Randgestaltung) der Schaltungsträger, ausschließlich durch einen einfachen, kostengünstigen und zuverlässigen Brechvorgang bewerkstelligt werden kann. Auf die partielle Verwendung von vollständigen Trennvorgängen mittels Sägen kann dadurch verzichtet werden. Die Ausgestaltung einer Durchgangsöffnung ist dabei prinzipiell beliebig. Eine Durchgangsöffnung kann rund, oval, polygonal, rechteckig, quadratisch oder dergleichen ausgebildet sein. Das Trägermaterial ist aus einem anorganischen Material hergestellt. Bei dem Trägermaterial handelt es sich bevorzugt um eine Keramik, weiter bevorzugt um eine Aluminium-Oxyd- oder eine Aluminium-Nitrid-Keramik.

Gemäß einer vorteilhaften Ausgestaltung ist der Durchmesser einer Durchgangsöffnung größer als die Breite der sich kreuzenden Trennlinien, die auch als Ritzspur bezeichnet wird. Der Durchmesser der Durchgangsöffnungen bewegt sich bevorzugt in einem Bereich zwischen 100µm und 500µm. Bevorzugt beträgt Durchmesser 150µm. Die Breite der Trennlinien ist im Wesentlichen dadurch bedingt, mit welchem Herstellungsprozess diese erzeugt werden. Das Anritzen (d.h. das Erzeugen einer Trennlinie für einen Brechvorgang) kann beispielsweise mittels eines Ritzstichels, einer Trennscheibe oder einem Laser erfolgen. Bei nicht-gesinterten Keramiken kann die Soll-Bruchlinie auch mittels eines Kerbmessers eingebracht werden (embossing). Für die zuverlässige Wirkung der Erfindung ist von Bedeutung, dass die Größe und Anordnung einer Durchgangsöffnung derart bemessen ist, dass die längs einer Trennlinie verlaufende Energiewelle gezielt in der Durchgangsöffnung endet und nicht seitlich daran vorbei laufen kann.

Die Größe und Anordnung der Durchgangsöffnungen relativ zu den sich kreuzenden Trennlinien ist bevorzugt der Gestalt, dass sich die Ränder der sich kreuzenden Trennlinien im Bereich einer Durchgangsöffnung nicht treffen. Hierdurch kann ein Vorbeilaufen der Energiewelle bei einem Bruch längs einer Trennlinie verhindert werden.

In einer anderen Ausgestaltung der Erfindung ist der Leiterplattennutzen mehrlagig ausgebildet, mit zumindest einer im Inneren des Trägermaterials verlaufenden Metallisierungslage.

Der nach dem Vereinzeln entstehende erfindungsgemäße Schaltungsträger weist zumindest zwei nicht-orthogonal aneinander grenzende Seitenränder zur Ausbildung einer Ecke auf, wobei der Schaltungsträger im Bereich dieser Ecken jeweils eine zum Inneren des Schaltungsträgers gewandte Einbuchtung aufweist. Die Einbuchtung ist durch die in dem Leiterplattennutzen eingebrachten Durchgangsöffnungen bedingt.

Mit dem erfindungsgemäßen Verfahren sind die gleichen Vorteile verbunden, wie sie oben im Zusammenhang mit dem Leiterplattennutzen bzw. dem Schaltungsträger beschrieben wurden.

Das erfindungsgemäße Verfahren eignet sich insbesondere zum Herstellen von Schaltungsträgern, welche zumindest zwei nicht-orthogonal aneinander grenzende Seitenränder zur Ausbildung einer Ecke aufweisen. Prinzipiell kann das Verfahren natürlich auch für solche Schaltungsträger eingesetzt werden, deren Randgestaltung lediglich orthogonal aufeinander treffende Seitenränder umfasst.

Das erfindungsgemäße Verfahren zum Vereinzeln von Schaltungsträgern aus einem Leiterplattennutzen umfasst die folgenden Schritte: Bereitstellen eines flächigen Trägermaterials; Vorsehen einer Mehrzahl an Trennlinien, welche die Größe und Randgestaltung der Schaltungsträger definieren; Vorsehen von Durchgangsöffnungen an Kreuzungspunkten der Trennlinien, die das Trägermaterial vollständig durchbrechen; und Vereinzeln der Schaltungsträger durch mechanisches Brechen entlang jeder der vorgesehenen Trennlinien.

Gemäß einer Ausgestaltung des erfindungsgemäßen Verfahrens umfasst der Schritt des Vorsehens der Trennlinien (Ritzspuren) ein Anritzen der Oberfläche des Trägermaterials. Dies kann durch sämtliche bekannte Herstellungsverfahren erfolgen. Besonders häufig werden Ritzstichel, Trennscheiben oder Laser eingesetzt.

Das Anritzen der Oberfläche des Trägermaterials kann vorteilhafterweise ein Erstellen von diskontinuierlich angeordneten Aussparungen erfassen, die entweder mechanisch oder bevorzugt mittels eines Lasers eingebracht werden. Die diskontinuierlich angeordneten Aussparungen bilden eine Trennlinie. Längs dieser Trennlinie ist das Trägermaterial derart geschwächt, dass bereits das Beaufschlagen mit lediglich geringen Kräften ein sauberes Brechen längs der Trennlinie verursacht. Mit Vorteil kann in diesem Verfahrensschritt auch gleichzeitig das Einbringen der Durchgangsöffnungen erfolgen. Dies kann jedoch auch mittels eines anderen Verfahrens als separater Verfahrensschritt erfolgen. Es muss lediglich sichergestellt sein, dass sich die Durchmesser der Aussparungen und der Durchgangsöffnungen voneinander unterscheiden, d.h. dass der Durchmesser einer Durchgangsöffnung ausreichend groß gegenüber den Aussparungen ist, um die inter- oder intrakristallin fortschreitende Energiewelle beim Brechen längs der Trennlinie zu stoppen, um ein seitliches "Vorbeilaufen" an der Durchgangsöffnung zu verhindern.

In einer alternativen Variante erfolgt das Vorsehen der das Trägermaterial durchbrechenden Durchgangsöffnungen durch eine Stanzung oder Prägung. Handelt es sich bei dem Trägermaterial um eine Keramik, so kann das Stanzen oder Prägen vorteilhafterweise vor dem Schritt des Sinterns des Leiterplattennutzens erfolgen. Im Gegensatz dazu erfolgt das Anritzen bzw. Vorsehen der das Trägermaterial durchbrechenden Durchgangsöffnungen erst nach dem Sinterschritt.

Weitere Merkmale, Vorteile und Ausgestaltungen der Erfindung werden nachfolgend anhand der Figuren näher erläutert. Es zeigen:
- Figur 1: einen erfindungsgemäßen Leiterplattennutzen zur Ausbildung einer Mehrzahl an Schaltungsträgern in einer Draufsicht,
- Figur 2: einen Ausschnitt aus dem Leiterplattennutzen der Figur 1 in einer Querschnittsdarstellung längs der Linie II-II,
- Figur 3: einen beispielhaften Schaltungsträger,
- Figur 4: einen vergrößerten Ausschnitt des Schaltungsträgers aus Figur 2,
- Figur 5: eine vergrößerte Darstellung eines Ausschnitts des Leiterplattennutzens in einer Draufsicht, aus der die Größenverhältnisse von Durchgangsöffnungen und Trennlinien hervorgeht, und
- Figuren 6a bis 6c: verschiedene Ausgestaltungen von Durchgangsöffnungen.

In den nachfolgend beschriebenen Figuren sind gleiche Merkmale mit gleichen Bezugszeichen beschrieben. Die in den Figuren dargestellten Objekte sind nicht mit ihren tatsächlichen Größenordnungen zueinander dargestellt. Einzelne Merkmale sind lediglich zur besseren Beschreibung vergrößert dargestellt.

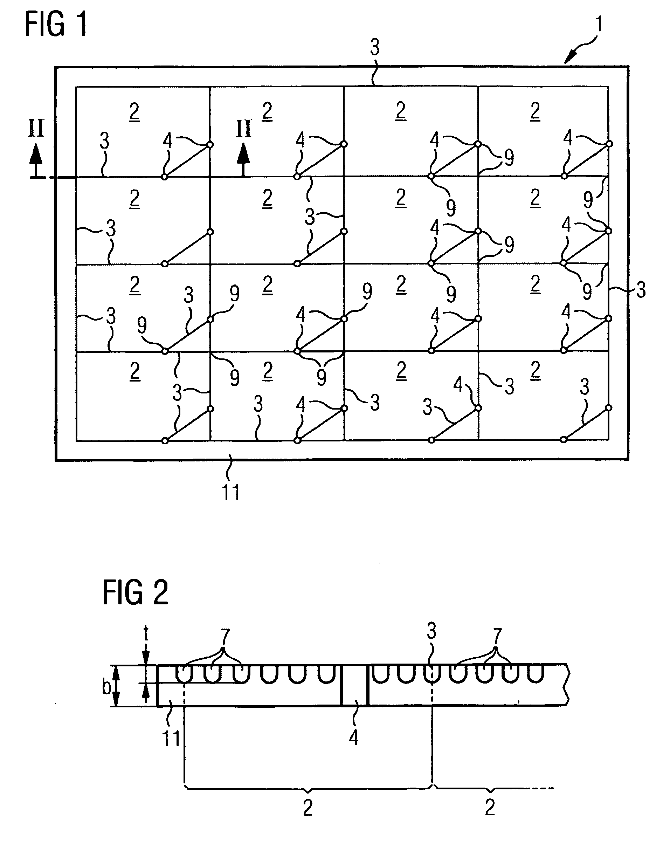

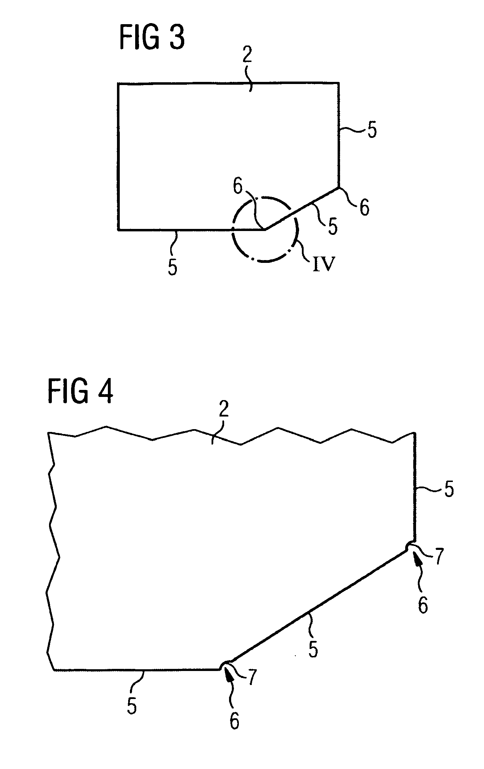

Figur 1 zeigt einen Leiterplattennutzen 1 aus einem Trägermaterial, der zur Ausbildung einer Mehrzahl an Schaltungsträgern 2 vorbereitet ist. Als Trägermaterial kommen insbesondere anorganische Materialien, insbesondere Keramiken und besonders bevorzugt Aluminium-Oxyd- oder Aluminium-Nitrid-Keramiken zum Einsatz. Der in Figur 1 gezeigte Leiterplattennutzen 1 weist lediglich zum Zwecke der Beschreibung insgesamt 16 darin ausgebildete Schaltungsträger 2 auf, die regelmäßig zueinander angeordnet und von einem optionalen Handlingrahmen 11 (sog. "handling frame") umgeben sind. Die Größe und Randgestaltung der jeweiligen Schaltungsträger 2 ist durch Trennlinien 3 definiert. Die endgültige, gewünschte Form eines Schaltungsträgers kann besser der Figur 3 entnommen werden. Aus dieser Figur ist ersichtlich, dass der Schaltungsträger 2 zwei Ecken 6 aufweist, deren aneinander grenzenden Seitenränder 5 einen nicht-orthogonalen Winkel zueinander aufweisen. Es ist deshalb notwendig, in dem Leiterplattennutzen 1 auch solche Trennlinien 3 vorzusehen, die gegenüber dem rechtwinkeligen Raster abweichen. Um beim Vereinzeln der Schaltungsträger 2 aus dem Leiterplattennutzen 1 unerwünschte Rissbildungen, insbesondere an denjenigen Ecken bzw. Kreuzungspunkten 9, zu vermeiden, an denen zwei Trennlinien 3 in einem nicht-orthogonalen Winkel aufeinandertreffen, sind an diesen Kreuzungspunkten so genannte Durchgangsöffnungen 4 vorgesehen, die das Trägermaterial des Leiterplattennutzens 1 vollständig durchbrechen.

Dies kann besser aus der Figur 2 ersehen werden, welche einen Ausschnitt des Leiterplattennutzens 1 längs der Linie II-II in Figur 1 in einer Querschnittsansicht zeigt. Gemäß dem Ausführungsbeispiel der Figur 2 sind die Trennlinien durch diskontinuierlich voneinander angeordnete Aussparungen 7 gebildet. Diese können - vorzugsweise in einem einzigen Verarbeitungsschritt zusammen mit den Durchgangsöffnungen 4 - mittels eines Laserverfahrens in das Trägermaterial des Leiterplattennutzens 1 eingebracht werden. Die Tiefe t dieser Aussparungen 7 beträgt dabei üblicherweise ca. 30% der Dicke b des Trägermaterials des Leiterplattennutzens 1. Für eine zuverlässige Fertigung hat es sich als vorteilhaft herausgestellt, die Tiefe t nicht wesentlich größer als 50% der Dicke b des Trägermaterials zu wählen. Im Gegensatz dazu ist aus der Querschnittsansicht der Figur 2 gut ersichtlich, dass die Durchgangsöffnungen 4 das Trägermaterial des Leiterplattennutzens 1 vollständig durchbrechen. Diese Durchgangsöffnungen ermöglichen das Stoppen einer Energiewelle längs einer Trennlinie beim Vereinzeln der jeweiligen Schaltungsträger aus dem Leiterplattennutzen 1.

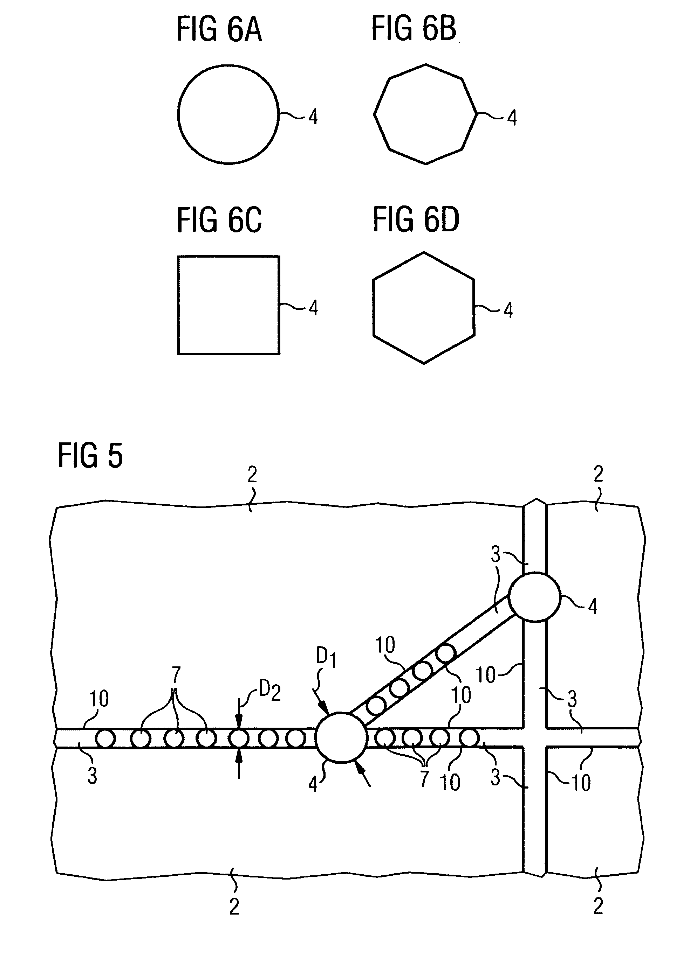

Die Ausgestaltung der Durchgangsöffnungen 4 kann prinzipiell beliebiger Art sein. In Figur 6 sind beispielhaft vier mögliche Querschnittsformen dargestellt. Bevorzugt, da am einfachsten zu fertigen, sind im Wesentlichen kreisrunde Ausgestaltungen (Figur 6a). Denkbar ist jedoch auch, den Querschnitt polygonal auszuführen. Figur 6b zeigt eine oktagonale Anordnung, Figur 6c eine rechteckige (quadratische) Anordnung, während Figur 6d eine hexagonale Querschnittsform zeigt.

Das Einbringen der Durchgangsöffnungen 4 kann prinzipiell auf beliebige Art und Weise erfolgen. Sofern das Herstellen der Trennlinien 3 mittels eines Lasers erfolgt, wie dies beispielsweise im Zusammenhang mit der Figur 2 erläutert wurde, ist es besonders vorteilhaft, auch die Durchgangsöffnungen 4 mit einem Laser herzustellen. Alternativ können diese jedoch auch durch eine Prägung oder Stanzung erzeugt worden sein. Im Falle der Stanzung ist es vorteilhaft, diesen Verfahrensschritt vor dem Sintern des Trägermaterials des Leiterplattennutzens durchzuführen.

Um die beim Brechen entstehende Energiewelle längs der Trennlinie zuverlässig stoppen zu können, ist es notwendig, dass der Durchmesser D₁ einer Durchgangsöffnung 4 größer als die Breite D₂ der Trennlinien 3 ist (Figur 5). Die Größe und Anordnung der Durchgangsöffnungen 4 relativ zu den sich kreuzenden Trennlinien muss dabei der Gestalt sein, dass sich die Ränder 10 sich kreuzender Trennlinien 3 im Bereich der Durchgangsöffnung 3 nicht treffen. Die Größe einer Durchgangsöffnung ist damit von der Breite einer Trennlinie 3 abhängig. Bei Versuchen hat es sich als vorteilhaft herausgestellt, den Durchmesser D₁ der Durchgangsöffnungen im Bereich zwischen 100µm und 500µm zu wählen. Besonders bevorzugt ist ein Durchmesser von 150µm. Je größer der Durchmesser D₁ der Durchgangsöffnungen 4 gewählt wird, desto größer und deutlicher sind Einbuchtungen 7 an den Ecken 6 erkennbar, an denen benachbarte Seitenränder in einem nicht-orthogonalen Winkel zueinander angeordnet sind. Dies ist aus Figur 4 besonders gut ersichtlich.

Das Vorsehen der Durchgangsöffnungen 4 ermöglicht das Vereinzeln von Schaltungsträgern aus einem Leiterplattennutzen alleine durch einen mechanischen Brechvorgang längs vorgefertigter Trennlinien. Ein Verzicht auf andere mechanische Bearbeitungsweisen, z.B. mittels einer Säge, ist durch das erfindungsgemäße Vorgehen möglich geworden.

## Patentansprüche

1. Leiterplattennutzen (1) mit einer Vielzahl an darin ausgebildeten Schaltungsträgern (2), wobei die Größe und Randgestaltung jedes der Schaltungsträger (2) durch eine Mehrzahl an in den Leiterplattennutzen eingebrachten und sich kreuzenden Trennlinien (3) einer bestimmten Breite definiert ist, und wobei an zumindest manchen Kreuzungspunkten (9) der Trennlinien (3) durch den Leiterplattennutzen hindurchreichende Durchgangsöffnungen (4) vorgesehen sind,
**dadurch gekennzeichnet, dass**
der Leiterplattennutzen (1) aus einem anorganischen Trägermaterial gebildet ist, in welchem die Trennlinien (3) ausgebildet sind.

2. Leiterplattennutzen nach Anspruch 1,
**dadurch gekennzeichnet, dass**
die Durchgangsöffnungen (4) an den Kreuzungspunkten (9) der Trennlinien (3) vorgesehen sind, an denen sich zumindest zwei Trennlinien in einem nicht-orthogonalen Winkel kreuzen.

3. Leiterplattennutzen nach Anspruch 1 oder 2,
**dadurch gekennzeichnet, dass**
der Durchmesser einer Durchgangsöffnung (4) größer als die Breite der sich kreuzenden Trennlinien (3) ist.

4. Leiterplattennutzen nach einem der vorhergehenden Ansprüche,
**dadurch gekennzeichnet, dass**
die Größe und Anordnung der Durchgangsöffnungen relativ zu den sich kreuzenden Trennlinien (3) derart ist, dass sich die Ränder (10) der sich kreuzenden Trennlinien im Bereich der Durchgangsöffnung (4) nicht treffen.

5. Leiterplattennutzen nach einem der vorhergehenden Ansprüche,
**dadurch gekennzeichnet, dass**
der Leiterplattennutzen (1) mehrlagig, mit zumindest einer im Inneren des Trägermaterials verlaufenden Metallisierungslage, aufgebaut ist.

6. Verfahren zum Vereinzeln von Schaltungsträgern (2) aus einem Leiterplattennutzen (1), mit den Schritten:
- Bereitstellen eines flächigen, anorganischen Trägermaterials;
- Vorsehen einer Mehrzahl an in dem Trägermaterial ausgebildeten Trennlinien (3), welche die Größe und Randgestaltung der Schaltungsträger (2) definieren;
- Vorsehen von Durchgangsöffnungen (4) an Kreuzungspunkten (9) der Trennlinien (3), die das Trägermaterial vollständig durchbrechen; und
- Vereinzeln der Schaltungsträger (2) durch mechanisches Brechen entlang jeder der vorgesehenen Trennlinien (3).

7. Verfahren nach Anspruch 6,
**dadurch gekennzeichnet, dass**
der Schritt des Vorsehens der Trennlinien (3) ein Anritzen der Oberfläche des Trägermaterials umfasst.

8. Verfahren nach Anspruch 7,
**dadurch gekennzeichnet, dass**
das Anritzen der Oberfläche des Trägermaterials ein Erstellen von diskontinuierlich angeordneten Aussparungen umfasst.

9. Verfahren nach einem der Ansprüche 6 bis 8,
**dadurch gekennzeichnet, dass**
das Vorsehen der das Trägermaterial durchbrechenden Durchgangsöffnungen (4) in einem Verarbeitungsschritt mit dem Anritzen der Oberfläche des Trägermaterials erfolgt.

10. Verfahren nach einem der Ansprüche 6 bis 8,
**dadurch gekennzeichnet, dass**
das Vorsehen der das Trägermaterial durchbrechenden Durchgangsöffnungen (4) durch Stanzung oder durch Prägung erfolgt.

11. Verfahren nach Anspruch 10,
**dadurch gekennzeichnet, dass**
eine Stanzung vor dem Sintern des Leiterplattennutzens (1) erfolgt.

12. Verfahren nach Anspruch 10,
**dadurch gekennzeichnet, dass**
eine Prägung vor dem Sintern des Leiterplattennutzens (1) erfolgt.

## Claims

1. Circuit board panel (1) with a multiplicity of circuit carriers (2) embodied therein, the size and perimeter design of each of said circuit carriers (2) being defined by a multiplicity of dividing lines (3) of a specific width inserted into the circuit board panel and intersecting each other, and where through-openings (4) are provided at at least a number of the points of intersection (9) of the dividing lines (3), said through-openings passing right through the circuit board panel,
**characterised in that** said circuit board panel (1) is formed from an inorganic carrier material in which the dividing lines (3) are embodied.

2. Circuit board panel according to claim 1,
**characterised in that** the through-openings (4) are provided at the points of intersection (9) of the dividing lines (3), at which at least two dividing lines intersect at a non-orthogonal angle.

3. Circuit board panel according to claim 1 or 2,
**characterised in that** the diameter of a through-opening (4) is greater than the width of the intersecting dividing lines (3).

4. Circuit board panel according to one of the preceding claims,
**characterised in that** the size and arrangement of the through-openings relative to the intersecting dividing lines (3) is such that the edges (10) of the intersecting dividing lines do not meet in the area of the through-opening (4).

5. Circuit board panel according to one of the preceding claims,
**characterised in that** the circuit board panel (1) is constructed in multilayered form, with at least one surrounding metallised layer being incorporated in the interior of the carrier material.

6. Method for individual separation of circuit carriers (2) from a circuit board panel (1) with the following steps:
- provision of a flat-surfaced, inorganic carrier material;
- provision of a multiplicity of dividing lines (3) embodied in the carrier material which define the size and perimeter design of the circuit carrier (2);
- provision of through-openings (4) at the points of intersection (9) of the dividing lines (3), which completely penetrate the carrier material; and
- individual separation of the circuit carrier (2) through mechanical breaking along each of the provided dividing lines (3).

7. Method according to claim 6,
**characterised in that** the step involving provision of the dividing lines (3) comprises scribing of the surface of the carrier material.

8. Method according to claim 7,
**characterised in that** the scribing of the surface of the carrier material comprises the creation of discontinuously arranged recesses.

9. Method according to one of the claims 6 to 8,
**characterised in that**
the provision of the through-openings (4) penetrating the carrier material takes place in one processing step with the scribing of the surface of the carrier material.

10. Method according to one of the claims 6 to 8,
**characterised in that** the provision of through-openings (4) penetrating the carrier material takes place by means of stamping or embossing.

11. Method according to claim 10,
**characterised in that** stamping takes place prior to sintering of the circuit board panel (1).

12. Method according to Claim 10,
**characterised in that** embossing takes place prior to sintering of the circuit board panel (1).

## Revendications

1. Flan pour carte à circuit imprimé (1) comprenant une pluralité de supports de circuits (2) réalisés dedans, dans lequel la dimension et la conformation en bordure de chacun des supports de circuits (2) sont définies par une pluralité de lignes de séparation (3) d'une largeur déterminée, lesquelles sont ménagées dans le flan pour carte à circuit imprimé et se croisent, et dans lequel des ouvertures de passage (4) s'étendant à travers le flan pour carte à circuit imprimé sont prévues sur au moins certains points de croisement (9) des lignes de séparation (3),
**caractérisé en ce que**
le flan pour carte à circuit imprimé (1) est formé à partir d'un matériau porteur inorganique dans lequel les lignes de séparation (3) sont réalisées.

2. Flan pour carte à circuit imprimé selon la revendication 1,
**caractérisé en ce que**
les ouvertures de passage (4) sont prévues aux points de croisement (9) des lignes de séparation (3), sur lesquels au moins deux lignes de séparation se croisent dans un angle non orthogonal.

3. Flan pour carte à circuit imprimé selon la revendication 1 ou 2,
**caractérisé en ce que**
le diamètre d'une ouverture de passage (4) est plus grand que la largeur des lignes de séparation (3) qui se croisent.

4. Flan pour carte à circuit imprimé selon l'une des revendications précédentes,
**caractérisé en ce que**
la dimension et la disposition des ouvertures de passage par rapport aux lignes de séparation (3) qui se croisent est telle que les bords (10) des lignes de séparation qui se croisent ne se rencontrent pas dans la zone de l'ouverture de passage (4).

5. Flan pour carte à circuit imprimé selon l'une des revendications précédentes,
**caractérisé en ce que**
le flan pour carte à circuit imprimé (1) est structuré en plusieurs couches, avec au moins une couche de métallisation s'étendant à l'intérieur du matériau porteur.

6. Procédé pour séparer des supports de circuits (2) depuis un flan pour carte à circuit imprimé (1), comportant les étapes de :
- mise à disposition d'un matériau porteur surfacique inorganique ;
- prévision d'une pluralité de lignes de séparation (3) réalisées dans le matériau porteur, lesquelles définissent la dimension et la conformation en bordure de chacun des supports de circuits (2) ;
- prévision d'ouvertures de passage (4) aux points de croisement (9) des lignes de séparation (3), lesquelles percent entièrement le matériau porteur ; et
- séparation des supports de circuits (2) par brisure mécanique le long de chacune des lignes de séparation prévues (3).

7. Procédé selon la revendication 6,
**caractérisé en ce que**
l'étape de la prévision des lignes de séparation (3) comporte une incision de la surface du matériau porteur.

8. Procédé selon la revendication 7,
**caractérisé en ce que**
l'incision de la surface du matériau porteur comporte l'élaboration d'évidements agencés avec discontinuité.

9. Procédé selon l'une des revendications 6 à 8,
**caractérisé en ce que**
la prévision des ouvertures de passage (4) qui percent le matériau porteur a lieu en une étape d'usinage avec l'incision de la surface du matériau porteur.

10. Procédé selon l'une des revendications 6 à 8,
**caractérisé en ce que**
la prévision des ouvertures de passage (4) qui percent le matériau porteur a lieu par estampage ou par matriçage.

11. Procédé selon la revendication 10,
**caractérisé en ce que**
un estampage a lieu avant le frittage du flan pour carte à circuit imprimé (1).

12. Procédé selon la revendication 10,
**caractérisé en ce que**
un matriçage a lieu avant le frittage du flan pour carte à circuit imprimé (1).
